Europäisches Patentamt

European Patent Office

Office européen des brevets

(19)

(11) Publication number: **0 338 150**
**A1**

(12) **EUROPEAN PATENT APPLICATION**

(21) Application number: **88303504.0**

(22) Date of filing: **19.04.88**

(51) Int. Cl.⁴: **H05K 3/36**

(43) Date of publication of application:
**25.10.89 Bulletin 89/43**

(84) Designated Contracting States:
**BE CH DE FR GB IT LI NL**

(71) Applicant: **DIAPHON DEVELOPMENT AB**

**S-431 24 Molndal(SE)**

(72) Inventor: **Mangold, Stephan Eberhard**
**PL 3532 Nordgard**
**S-4413 Alingsas(SE)**

(74) Representative: **Cross, Rupert Edward Blount et al**
**BOULT, WADE & TENNANT 27 Furnival Street London EC4A 1PQ(GB)**

(54) **A method of producing electronic basic blocks with a high degree of compaction and basic blocks produced according to method.**

(57) A flexible printed circuit card (21a, 21b) is produced by providing a flexible card material (11) with folding indications (12a, 12b, 12c) extending wholly or partly through the card and the card material (11) is covered at least on one side with a foil. Electronic components (13) are attached to the card material, and the circuit card is perforated or cut out of the card material. The folding indications (12a, 12b, 12c) enable the flexible card to be folded with sharp, minimum radius corners, which makes it possible to mount integrated circuits (13) and components very close to the edges or corners of the card. When the card material (11) is folded along the folding indications (12a, 12b, 12c) to form an enclosed basic block, a number of tabs (22, 23, 24, 25) are formed which are substantially connected with each other by the foil. The folded carrier also forms at least one partially enclosed space that can be filled with a dielectric cast compound, thereby encasing all the components (13) of the basic block and protecting them against relatively rough treatment of the unit.

**FIG 9**

# A METHOD OF PRODUCING ELECTRONIC BASIC BLOCKS WITH A HIGH DEGREE OF COMPACTION AND BASIC BLOCKS PRODUCED ACCORDING TO METHOD

The present invention relates to methods of producing electronic basic blocks in miniature shape, particularly with a high degree of compaction within a limited volume. The invention also relates to flexible printed circuits produced according to the method.

## BACKGROUND OF THE INVENTION

For certain electronic devices there is a need for a very high degree of compaction within a small accessible volume. An example is hearing aids having an electronic unit carried behind the ear, or even in the ear or within the auditory canal. In a hearing aid, the entire electronic apparatus should be kept within a volume which, for example, has the shape of a parallelepiped of the size 5 x 7.5 x 6 mm.

Typically, a large number of integrated circuits and active and passive components must be included within such an electronic unit, which makes it difficult for the electronic unit to fit in the preferred form. Furthermore, the extensive wiring required for interconnecting the components, combined with the high demand for miniaturizing, makes it nearly impossible to divide the electronic components into a number of discrete printed circuit cards because the standard contacts between printed circuit cards are too bulky.

A number of prior art systems use integrated circuits and components mounted on flexfilm, but these usefulness of these flexfilm circuits has been limited by the rather large radius of folds in the flexfilm. As a result, the integrated circuits and components cannot be mounted close to the fold, and the degree of compaction of the circuits has been limited.

It is therefore an object of the present invention to provide a manufacturing method and a basic block which exhibits a high degree of compaction within a very limited, accessible volume, without bulky wiring. Another object of the present invention is that the method should utilize well established and highly mechanized flexible film handling techniques, so that safe connections between integrated circuits and the other components are reliably achieved. Another object of the invention is to provide a manufacturing method that makes it possible to enclose all components in a dielectric cast compound, so that the electronic apparatus will withstand rough treatment.

## SUMMARY OF THE INVENTION

In summary, the present invention provides a method of producing a basic block having at least one bendable carrier serving as a flexible printed circuit. The bendable carrier is provided with folding indications, along which the carrier is folded, with the carrier forming at least one part of the outer limiting walls of the basic block. The bendable carrier supports electronic components and also a conductive pattern for interconnecting electronic components. The folding indications enable the carrier to be folded with sharp, minimum radius corners, which makes it possible to mount integrated circuits and components very close to the edges or corners of the carrier. When folded, the bendable carrier forms at least one partially enclosed space that can be filled with a dielectric cast compound, thereby encasing all the components of the basic block and protecting them against relatively rough treatment of the unit.

## BRIEF DESCRIPTION OF THE DRAWINGS

Additional objects and features of the invention will be more readily apparent from the following detailed description and appended claims when taken in conjunction with the drawings, in which:

Figure 1 shows an enlarged horizontal view of a part of the carrier material for a basic block in an initial manufacturing stage.

Figure 2 shows the carrier material according to Figure 1 after a conductive pattern has been applied thereto.

Figure 3 shows a horizontal view of a carrier part which has been removed from the carrier material shown in Figures 1 and 2.

Figure 4 shows another carrier produced in a corresponding way and intended to be attached and connected with the carrier part shown in Figure 3.

Figures 5 through 8 show four different types of folding indications in a carrier material, each figure showing a cross section view of one type of folding indication cut into a carrier material, a view from above the material, and a view parallel to the folding plane after the bending of the material along the folding indication.

Figure 9 shows in perspective the printed circuit cards of Figures 3 and 4 folded into a parallelepipedic shape.

## DESCRIPTION OF THE PREFERRED EMBODIMENTS

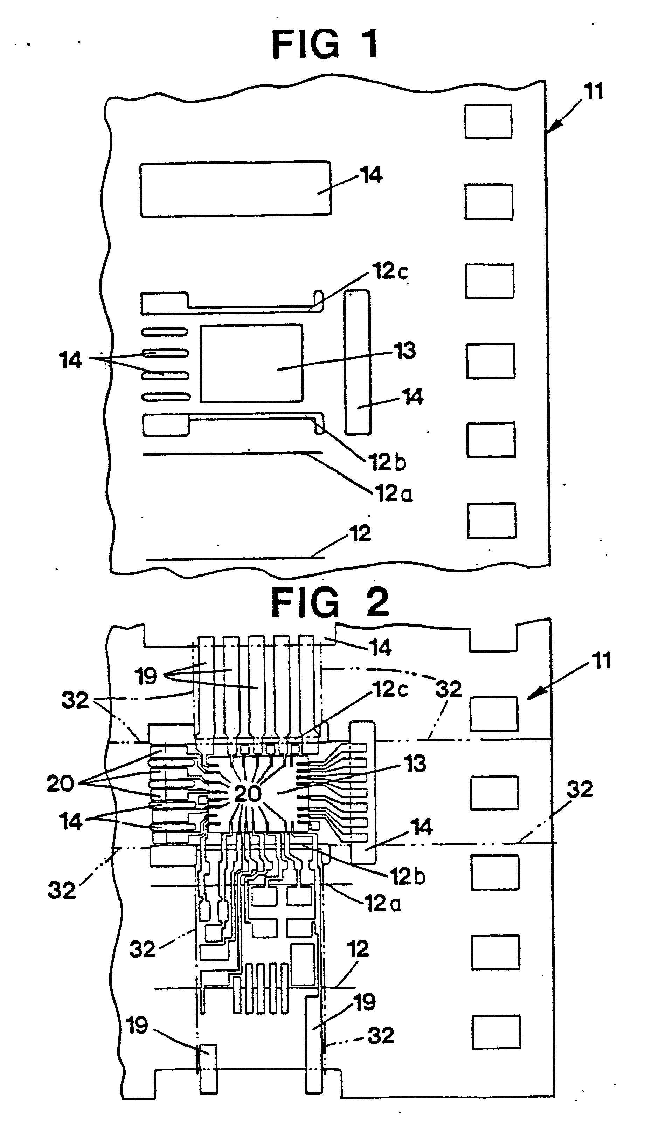

Referring to Figure 1, the preferred starting material for the manufacturing of basic blocks is a flexible plastic film 11, such as flex film or Kapton film. The film 11 preferably has the shape of a standard photographic film size, such as 35mm film-size, to facilitate handling of the film by enabling the usage of conventional film handling equipment.

For convenience, the film 11 is sometimes called the carrier material or card material (for a circuit card).

The first manufacturing step is to cut or otherwise apply folding indications 12a, 12b and 12c to the carrier material 11. As explained in more detail below, each folding indication may extend partially or wholly through the carrier material 11. The purpose of the folding indications is to enable the carrier material 11 to be folded in a corresponding pattern. When the carrier material 11 is folded, later in the manufacturing process, each of the resulting sections of the carrier material is called a tab.

Apertures 13 and 14 are also punched or removed from the carrier material 11 to provide room for connecting integrated circuits and other components to a conductive pattern that will applied to the carrier material 11.

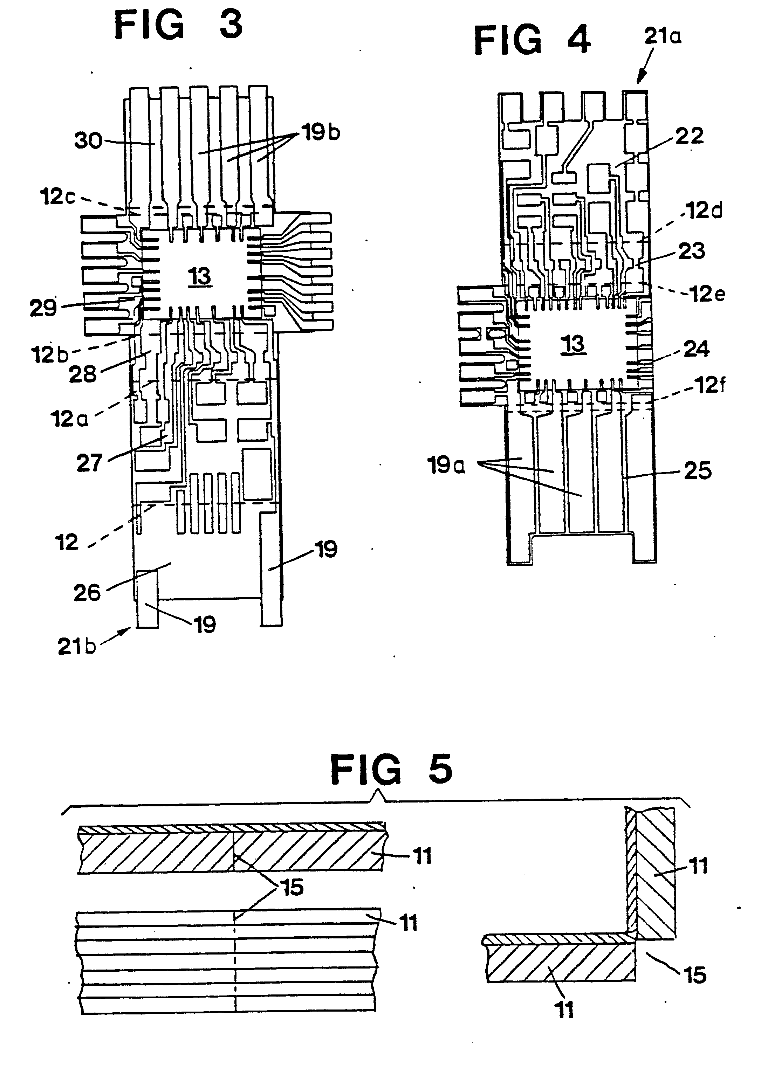

Referring to Figures 5 - 8, folding indications can be made in several different ways, and can extend partially or wholly through the carrier material 11, depending on the thickness and bending ability of the carrier material 11, the amount or degree that the carrier material 11 is to be bent, and also on the manufacturing sequence of the circuit cards. Each of these Figures shows three views of a folding indication in a carrier material 11: a cross section view of the material with a folding indication cut into the material, a view from above the material, and a view parallel to the folding plane after the carrier material 11 has been bent along the folding indication.

As shown in Figure 5, folding indications 15 can be made by scribing, a fractural indication, or by making a cut through the material 11. This technique is most often used for foldings of 90° or less.

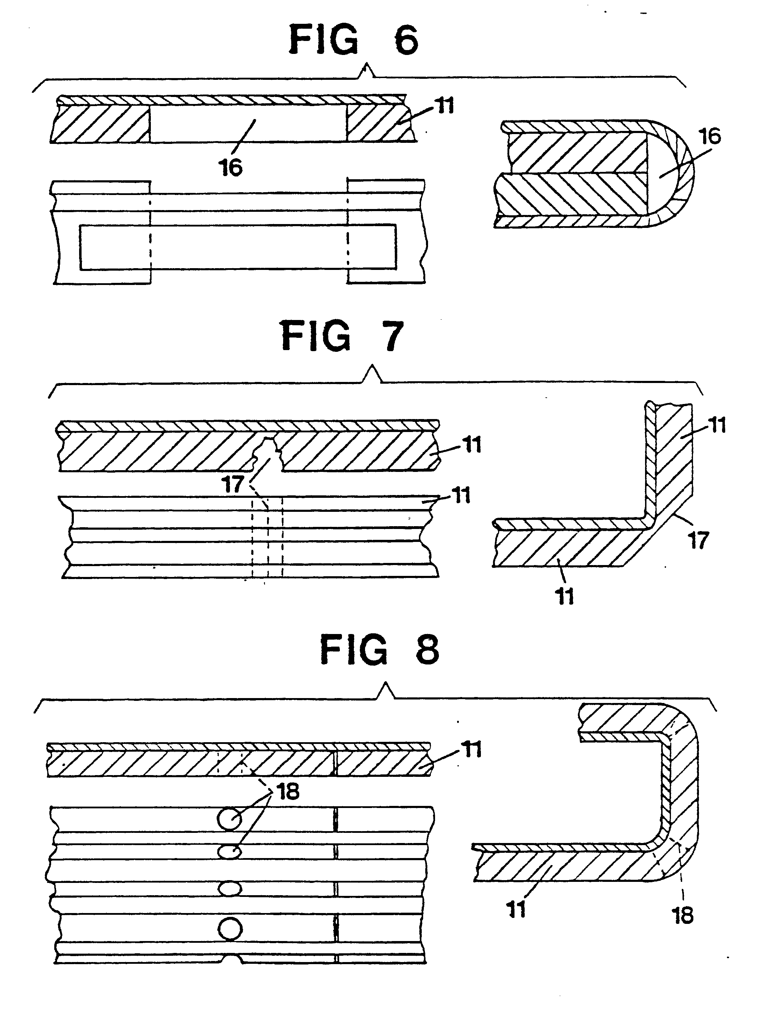

Referring to Figure 6, for foldings of 180° the folding indications are preferably made by punching out a portion of the material 11. The width of the punched out portion should be more than double the thickness of the material 11 for foldings of 180°.

Referring to Figure 7, in some cases, folding indications can be made by etching a dike 17 part way through the carrier material 11. Another method of providing folding indications, shown in Figure 8 is to perforate the material 11 with perforation holes 18, for example, using a laser beam to make the holes 18. Both these last mentioned methods can also be used at a later stage of manufacturing the circuit cards. Generally, an important aspect of the folding indications is that they enable the carrier to be folded with sharp, minimum radius corners, which makes it possible to mount integrated circuits and components very close to the edges or corners of the carrier.

The next phase of the manufacture, after the provision of the folding indications, is to form a conductive pattern 19 on the carrier material 11. The material 11 is covered with a glue coating and a thin copper foil is glued over the entire material. In the conventional way, the desired conductive pattern 19 is then formed using photolithography to etch away the copper foil from the places where the copper is not desired.

In the preferred embodiment, as shown in Figure 2, free connection tabs 20 are formed in the apertures 13 and 14 from the copper foil for connections to integrated circuits and other components which are to be mounted on the carrier 11. The connection tabs 20 can also be used to connect the electronic basic block (i.e., the circuit card being manufactured) to an external substrate or a printed circuit card. After the conductive pattern has been applied to the material 11 it can be tinned.

The next phase of manufacture is the connection of integrated circuits and other electronic components, which are either mounted with "internal lead bonds" and/or are soldered to the free connection tabs 20. Next, the resulting circuit is inspected and tested to ensure the integrity of the components and the conductive pattern, and then a circuit card is punched or cut out of the film material 11 along the dotted and dashed contour lines 32 shown in Figure 2. The resulting part, or circuit card, is shown in Figure 3. Another circuit card produced in a similar manner, but with a different design pattern, is shown in Figure 4.

Referring to Figures 3, 4 and 9, the next step of the manufacturing process is to bend and interconnect two or more circuit cards to form a basic block. The number of separate circuit cards used will of course depend on the purpose and design of the electronic unit being made, and on the number and placement of the outer connections to the unit which are needed. In some circumstances, a single circuit card with several bending indications can be used to form a self enclosed basic block.

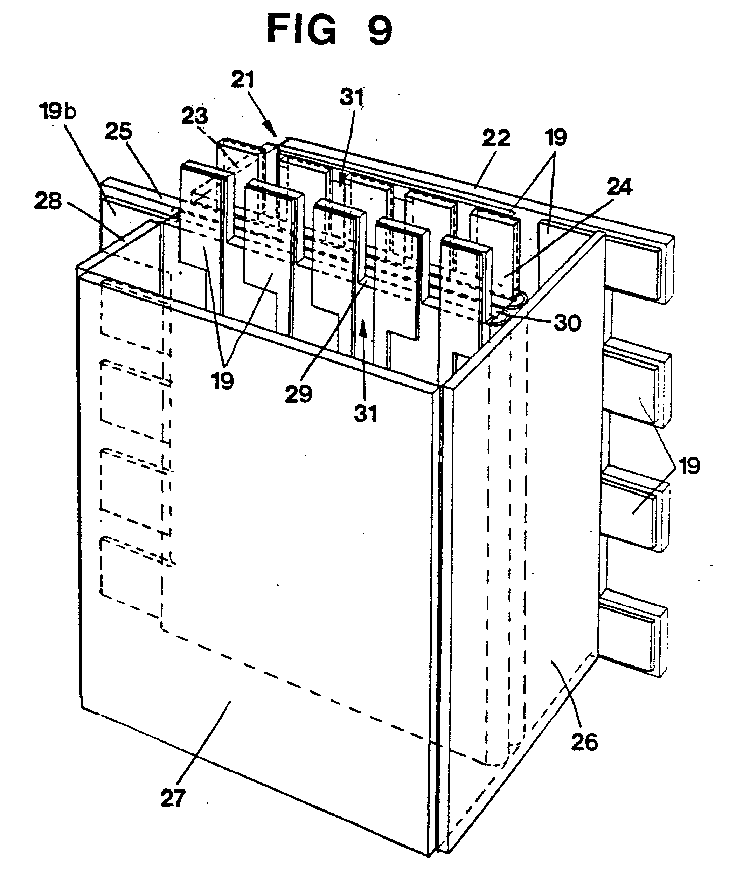

In the preferred embodiment shown in Figure 9, the basic block has a number of outer connections, some of which are directed upwards and others of which are directed laterally in separate directions. As a result, the basic block has been made in two parts, circuit cards 21a and 21b, shown in Figures 4 and 3, respectively.

Circuit card 21a has four sets of connection tabs 22, 23, and 24 and 25 separated by the folding indications 12d, 12e and 12f. Folding indications 12d and 12e are cuts or scribings (such as the cut 15 shown in Figure 5) for forming 90° corners. The folding indication 12f is formed by punching out a portion of the carrier material, as shown in Figure 5, to enable a 180° bending of the carrier material.

Circuit card 21b has connection tabs 26 - 30 separated by folding indications 12, 12a, 12b and 12c. Folding indications 12, 12a and 12b are for forming 90° corners, while folding indication 12c is for enabling a 180° bending of the carrier material.

When putting together the two circuit cards 21a and 21b to from the basic block shown in Figure 9, tabs 25 and 30 are placed facing each other so that the parts of the conductive pattern 19a on tab 25 will contact the corresponding parts of the conductive pattern 19b on tab 30. The conductive patterns on the two tabs 25 and 30 are soldered together. Then the two circuit cards 21a and 21b are folded away from each other, each being folded 180° along folding indications 12f and 12c, respectively. At this point, the integrated components inserted in the apertures 13 in each of the circuit cards (i.e., on tabs 24 and 29) will be located on opposite sides of the soldered tabs 25 and 30. Thus tabs 24, 25, 29 and 30 form a partition extending across the center of the electronic basic block shown in Figure 9, and this partition provides the structural support for the two integrated circuits inserted in the apertures 13.

Circuit card 21b is then folded along folding indications 12b, 12a, and 12 so that tab 28 forms the left-front sidewall, tab 27 forms the front sidewall, and tab 26 forms the right sidewall of the basic block. Circuit card 21a is folded along folding indications 12e and 12d so that tab 23 forms the left-rear sidewall, and tab 22 forms the rear sidewall.

Figure 9 shows the resulting basic block, which has the shape of a parallelepiped. Note that in this preferred embodiment the conductive patterns on the tabs which form the sidewalls are facing the interior of the basic block.

The folded together circuit cards 21a and 21b are then fixed in their folded positions, for example, by wrapping a thin strap around the circumference of the basic block, or by gluing rigid L-shaped parts onto its 90° edges. A permanent fixing is provided by filling the inclusion 31, i.e., the space 31 which is partially surrounded or enclosed by the two circuit cards, with a dielectric cast compound. In this way all the components will be encased and well protected even against relatively rough treatment of the unit.

While the present invention has been described with reference to a few specific embodiments, the description is illustrative of the invention and is not to be construed as limiting the invention. Various modifications may occur to those skilled in the art without departing from the true spirit and scope of the invention as defined by the appended claims.

For example, two separate foils can be used: one for the conductive pattern, and one for interconnections between different tabs (i. e., sections of the carrier material). The foil or foils used can also be arranged on one or both sides of the carrier material.

## Claims

1. A method to produce electronic basic blocks in miniature shape with a high degree of compaction within a very limited volume, the steps of the method comprising:
providing at least one bendable carrier, said carrier being capable of supporting electronic components and a conductive pattern;
forming folding indications in the bendable carrier along which the carrier will be folded;
folding the bendable carrier along the folding indications to form at least one part of an outer limiting wall of a basic block.

2. A method as set forth in Claim 1, wherein said step of forming folding indications includes steps selected from the set consisting essentially of removing material from said carrier at predefined locations, and forming recesses in the form of punchings, scribings, etchings, cuts, grooves, dikes, perforations or the like.

3. A method as set forth in Claim 1, including the step of forming on at least one side of said bendable carrier material an electrically conductive foil as a base for a desired conductive pattern, said foil at least partially extending over said folding indications.

4. A method as set forth in Claim 1, including the steps of forming a patterned, electrically conductive foil on at least one side of said bendable carrier; attaching electronic components to said bendable carrier and electrically connecting said components to said electrically conductive foil.

5. A method according to Claim 4, said folding step forming a number of tabs which are substantially connected with each other by said electrically conductive pattern, said method including the step of fixing said tabs in a folded position.

6. A method according to Claim 4, said folding step forming at least one space which is at least partially enclosed by the carrier, said method including the step of filling said at least one partially enclosed space with a dielectric cast compound to encase said electrical components.

7. An electronic basic block, comprising
a bendable carrier having a multiplicity of tabs separated from each other by folding indications,
a patterned, electrically conductive foil on at least one side of said carrier arranged to at least partially cover said folding indications,
said carrier being folded along said folding indications to form at least one partially enclosed space.

8. An electronic basic block according to Claim 7, said electronic basic block including a plurality of distinct electrical components coupled to and interconnected by said electrically conductive foil.

9. An electronic basic block according to Claim 8, wherein said at least one partially enclosed space is filed with a dielectric cast compound to encase said electrical components.

# FIG 1

# FIG 2

# FIG 3

# FIG 4

# FIG 5

## FIG 6

## FIG 7

## FIG 8

# FIG 9

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| X | US-A-3 427 715 (MOTOROLA INC.) <br> * Column 1, line 71 - column 2, line 16; column 3, line 25 - column 4, line 39; column 5, lines 4,5; figures 1-4 * | 1-5,7,8 | H 05 K 3/36 |
| X | DE-A-1 766 162 (SIEMENS AG) <br> * Page 2, paragraph 3; page 4, paragraphs 2-4; page 5, paragraph 3 - page 6, end; figures 1,2 * | 1,2,7-9 | |
| A | | 3-6 | |
| A | US-A-3 039 177 (ITT CORP.) <br> * Figure 5 * | 6,8 | |

TECHNICAL FIELDS SEARCHED (Int. Cl.4)

H 05 K

The present search report has been drawn up for all claims

| Place of search | Date of completion of the search | Examiner |
|---|---|---|
| THE HAGUE | 30-11-1988 | SCHUERMANS N.F.G. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

\.............................................................................

& : member of the same patent family, corresponding document

EPO FORM 1503 03.82 (P0401)